# EUROPÄISCHE PATENTSCHRIFT

(11) **EP 1 565 656 B1**
(45) Veröffentlichungstag und Bekanntmachung des Hinweises auf die Patenterteilung: **20.09.2006**
(21) Anmeldenummer: 03795731.3
(22) Anmeldetag: 13.11.2003
(51) Int. Cl.: H01L 21/00

(54) **HOCHDRUCKVORRICHTUNG ZUM VERSCHLIESSEN EINES BEHÄLTERS**
HIGH-PRESSURE DEVICE FOR CLOSING A CONTAINER IN A CLEAN ROOM
DISPOSITIF A HAUTE PRESSION POUR OBTURER UN RECIPIENT EN SALLE BLANCHE

(30) Priorität: 26.11.2002 DE 10255231
(43) Veröffentlichungstag der Anmeldung: 24.08.2005
(73) Patentinhaber: Uhde High Pressure Technologies GmbH, 58093 Hagen (DE)
(72) Erfinder: LÜTGE, Christoph, 59425 Unna (DE); KURTZ, Hans-Ottomar, 44139 Dortmund (DE)
(86) Internationale Anmeldenummer: PCT/DE2003/003756
(87) Internationale Veröffentlichungsnummer: WO 2004/048783

(56) Entgegenhaltungen:
- EP-A- 0 769 806
- WO-A-02/084709
- US-A- 5 314 574
- US-A1- 2001 029 971

## Beschreibung

Die Erfindung betrifft eine sehr kompakte Vorrichtung und ein Verfahren zum Verschließen eines Behälters mittels eines rotationssymmetrischen Hubsystems, welches einen Arbeitskolben und einen Führungszylinder enthält und im Wesentlichen mit dem selben Fluid betrieben wird, welches im Behälter als Prozessmedium eingesetzt wird. Die Stirnseite des Arbeitskolbens bildet dabei mindestens zum Teil das Verschlussteil des Behälters oder ist mit dem Verschlussteil starr verbunden. Dabei kommt als Arbeitsmedium zum Antrieb des Kolbens und als Prozessmedium idealerweise ein überkritisches Fluid zum Einsatz.

In der Halbleiterfertigung, der opto-elektronischen Industrie und in anderen Industriezweigen werden immer mehr Produkte entwickelt, die zentrale Funktionen mittels oder auf Basis von Mikro- oder Nanostrukturen realisieren. Diese Mikro- und Nanostrukturen sind vor allem während ihrer Produktion extrem empfindlich gegenüber geringsten Verunreinigungen. Daher werden an die Komponenten der Fertigungsverfahren höchste Ansprüche bzgl. der zulässigen Emissionen gestellt. Die erforderlichen Reinigungsschritte für nanostrukturierte Oberflächen sind z. T. mit üblichen Reinigungsflüssigkeiten nicht mehr oder nur sehr schwer möglich. Seit einiger Zeit werden in großem Maßstab daher überkritische Fluide eingesetzt, die verbesserte Benetzungs- und Reinigungseigenschaften aufweisen. Hierfür sind Prozessdrücke von 150 bis über 300 bar erforderlich, die besondere Ausrüstungen erfordern. Mechanisch geeignete Hochdruckaggregate waren bisher nicht oder nicht direkt reinraumtauglich. WO 02/084709 A2 beschreibt eine solche Reinigungsvorrichtung für Wafer, bei welcher der Boden des Prozessraumes ein Hochdruckstempel ist, welcher den Wafer trägt und den Prozessraum öffnet oder verschießt. Die Hubvorrichtung selbst wird in der WO 02/084709 A2 nicht näher beschrieben. Die vorliegende Erfindung beschreibt ein Hochdruckaggregat für den Einsatz im Reinraum, welches bei schnellem Lastwechsel auf hohem Druckniveau nur geringste Emissionen erzeugt und in einer sehr kompakten Bauform ausgeführt ist.

Hubaggregate für Drücke über 150 bar sind in vielfältigem technischen Einsatz und in der Patent- und Fachliteratur hinreichend beschrieben. Als Arbeitsmedien dienen Fluide und Gase, wobei für Drücke bis ca. 160 bar Wasser und über 160 bar vorrangig Hydrauliköle eingesetzt werden. Inerte Gase und Luft sind die üblichen gasförmigen Arbeitsmittel. Hydrauliköl weist wichtige positive Eigenschaften für die Hochdruckanwendung auf, die u. a. in der Schmierung der Gleitflächen, geringer Kompressibilität und hoher Temperaturbeständigkeit bestehen.

Nicht vollständig zu kompensierende nachteilige Effekte bei Kolbensystemen sind unter anderem Materialabtrag sowie Leckage des Arbeitsmediums. Reibungs- und druckbedingter Materialabtrag wie z. B. Abrieb, Verdampfung und Verflüssigung geschieht in geringem Maße an dem Basiswerkstoff selbst und vor allem am Dichtungssystem. Der Materialabtrag in Hubaggregaten ist im Wesentlichen abhängig von der Oberflächenbeschaffenheit der Gleitflächen und Fertigungstoleranzen der Bauteile, dem Dichtungsmaterial und dem radialen Anpressdruck der Dichtung sowie der Temperatur.

Die Leckage des Arbeitsmediums, welches bei jedem Krafthub in gewissen Mengen mitgeführt wird, ist unter anderem funktional von Oberflächenbeschaffenheit, Viskosität, hydrostatischem Druck im Zylinderraum sowie von der Dichtungskonstruktion und deren radialem Anpressdruck abhängig.

Hohe Arbeitsdrücke erfordern eine ausreichende Schmierung der sich berührenden und gegeneinander ablaufenden Flächen, was zu entsprechenden Leckagemengen führt. Dieser Effekt kann über geeignete Dichtungssysteme und eine hochwertige Oberflächenbearbeitung minimiert werden. Die Möglichkeit, den Anpressdruck zur Leckagerückhaltung zu erhöhen, ist allerdings dadurch begrenzt, dass mit steigendem Druck auch die Zerstörung bzw. der Abtrag des Dichtungsmaterials steigt, was ebenfalls Emission bewirkt und kurzfristig zu erhöhten Leckagemengen führt. Des Weiteren werden die Grenzen mechanischer Belastbarkeit und einer ökonomischen Betriebsweise erreicht.

Verunreinigungen aus Materialabtrag und Leckage aus den oben genannten Quellen sind im Produktionsbereich vor allem für Reinraumprozesse sehr nachteilig. Reinheitsklassen werden z. B. in der DIN 2083 oder im Federal Standard 209D definiert. Emissionen jeglicher Art beeinflussen direkt die Produktqualität in diesen Prozessen und werden mit hohem apparativen und organisatorischen Aufwand minimiert, was mit entsprechenden Kosten verbunden ist. Besonders schwerwiegend und nachteilig sind Verunreinigungen durch Ölnebel, da ölhaltige Immissionen häufig chemisch aktiv sind und nur mit lösungsmittelhaltigen Stoffen wieder zu entfernen sind, welche wiederum im Reinraum nicht erwünscht bzw. sehr nachteilig sind.

Für komplexere Fertigungsketten, bei denen reinraumtaugliche und wenig geeignete Komponenten zum Einsatz kommen, wird eine räumlich Trennung realisiert. In sogenannten "Maintenance Bereichen" werden die für den Reinraum nicht tauglichen Ausrüstungen und in sogenannten "White Rooms" die reinraumtauglichen Ausrüstungsteile untergebracht. Derartigen Lösungen erfordern aufwändige Schleusen und organisatorische Vorkehrungen, um die Rückhaltung von Verunreinigungen aus dem "Maintenance Bereich" sicherzustellen.

Es ist bekannt, dass ölhydraulische Hubsysteme im Reinraumeinsatz problematisch sind und durch geeignete Absaugung für Reinraumanwendungen tauglich gemacht werden können [SWISS Contamination Control 5(1992) Nr. 5, S. 8 ff]. Beim Einsatz eines Presswerkzeugs zur Produktion von CD-Platten traten Ölanhaftungen am Halbzeug auf. Untersuchungen ergaben, dass Quelle dieser Verunreinigung das Hydrauliköl war. Durch das Anbringen von geschlossenen Manschetten an die Schubstangen des Werkzeugs und das Absaugen des Pressengehäuses sowie der Luft aus den Manschetten konnte die gewünschte Reinraumtauglichkeit hergestellt werden.

Ein weiterer Fachartikel offenbart einen Pneumatikzylinder in einer kolbenstangenlosen Ausführung [Dr.-Ing. E. Fritz; Schrift zum 1. Int. Forum Fluidtechnisches Kolloquium, Band 2, S. 283 ff]. Die Reinraumtauglichkeit wurde erreicht, indem im Raum zwischen Abdeckband und Dichtband ein Teilvakuum erzeugt wurde. Hierzu wurden Vakuumanschlüsse auf dem Zylinderrohr angebracht und die Emissionen abgeführt.

Nachteilig an den vorgenannten Hubaggregaten mit Absaugung ist, dass zusätzliche Systeme zur Sicherstellung minimaler Partikelkonzentrationen erforderlich sind, welche installiert und permanent betrieben werden müssen.

In der Patentschrift US 5,314,574 wird eine Behandlungsvorrichtung offenbart, die ihren Einsatz im Rahmen der Waferproduktion findet. In der genannten Schrift wird ein Hubsystem offenbart, welches zur Erreichung der Reinraumtauglichkeit die erforderlichen Hubstangen und - zylinder von dem Prozessraum in der Art abgetrennt, indem entfaltbare Metallbälge zwischen der auskragenden Kolbenendplatte und der Bodenplatte des Prozessbehälters, durch welche der Hubkolben hindurchführt, befestigt sind. Somit ummanteln die Metallbälge Kolbenstange und Kolbenzylinder und werden bei jedem Hubvorgang ziehharmonikaartig ge- oder entfaltet. Eine vergleichbare Konstruktion wird in der Patentschrift US 5,259,407 offenbart. Nachteilig an derartigen Systemen ist die hohe Luftverdrängung an der Außenseite der Metallbälge, da durch die Faltung eine relativ große Oberfläche entsteht, die im Wesentlichen quer zur Bewegungsrichtung angeordnet ist und bei jedem Hub beschleunigt wird. Weiterhin nachteilig ist der hohe konstruktive Aufwand und eine zu erwartende Zerstöranfälligkeit des hoch beanspruchten Balgmaterials.

In der Patentschrift US 5,169,408 wird ein rotationssymmetrischer Apparat zur Behandlung von Waferscheiben offenbart, der unter anderem ein pneumatisches Hubsystem und einen Prozessbehälter umfasst, in welchen die Waferscheiben eingelegt werden und der eigentliche Prozess abläuft. Das Hubsystem wiederum umfasst mehrere pneumatisch angetriebene Hubkolben, wobei ein Pneumatikkolben zentrisch auf dem oberen Teil des Prozessbehälters befestig ist und zum Heben und Senken dieses Behälterteils dient. Am unteren Prozessbehälterteil sind mehrere Hubkolben rotationssymmetrisch außerhalb der Rotationsachse angebracht und dienen zum Heben und Senken des verbundenen unteren Behälterteils. Arbeitsmedien, die in dem durch die Patentschrift US 5,169,408 offenbarten Apparat zum Einsatz kommen, sind im Wesentlichen Stickstoff und Wasser. Nachteilig an der Erfindung ist das aufwändige Hubsystem, welches für einen Hebevorgang immer mehrere Hubkolben vorsieht, welche aufeinander abgestimmt getrieben werden müssen. Vor allem bei hohen Drücken ist eine absolut synchrone Fahrweise der Hubkolben erforderlich, was einen hohen Steuerungsaufwand erfordert. Der Einsatz von pneumatisch angetriebenen Hubkolben beschränkt den Einsatz der offenbarten Vorrichtung und des Verfahrens auf niedrige Drücke.

US 6,067,728 offenbart eine Vorrichtung und ein Verfahren zur Trocknung von Waferscheiben mittels überkritischem CO₂, wobei ein pneumatisch-mechanisches Verschlusssystem dargelegt wird. Der Verschluss des Behälterdeckels wird über einen pneumatischen Kolben und eine Hebelvorrichtung realisiert, wobei über diese Anordnung eine Vorpressung erreicht wird. Die Verriegelung des Deckels geschieht durch Klammern. Nach dem pneumatisch-mechanischen Verschluss des Prozessraumes werden eine oder mehrere statische Klammern symmetrisch am Rand des Deckels positioniert. Diese Klammerverschlüsse werden mechanisch über den Rand des Behälterdeckels und des Behälterbodens geschoben und gewährleisten bei steigendem Innendruck die Dichtheit des Behälters während des Prozesses.

Nachteilig an der vorgenannten Erfindung sind die vielen bewegten Teile, welche bzgl. der Emissionen als kritisch zu betrachten sind, und welche die Hubzahl bzw. mögliche Prozesszyklen pro Zeiteinheit durch die erforderlichen Wege stark begrenzen. Die vielen Abläufe erfordern weiterhin eine aufwändige Steuerung.

Aufgabe der vorliegenden Erfindung ist es, zusätzliche Absaugungs- und Sicherungssysteme bzw. die räumlichen Aufteilungen und den Einsatz mehrerer bzw. unterschiedlicher Prozess- und Arbeitsfluide durch konstruktive und verfahrenstechnische Lösungen am eigentlichen Hubsystem überflüssig zu machen. Weiterhin sollen Bauformen erreicht werden, die die Erfordernisse eines sicheren Reinraumbetriebes mit möglichst geringen Bewegungen und wenigen bewegten Bauteilen erzielen.

. Die vorliegende Erfindung löst diese Aufgabe gemäß dem Hauptanspruch, indem eine Hochdruckvorrichtung zum Verschließen eines Behälters unter Reinraumbedingungen, welcher im Wesentlichen mindestens aus einem Basisteil und einem Verschlussteil besteht und eine Dichtfläche zwischen diesen beiden Teilen aufweist, für die Durchführung eines Prozesses mit mindestens einem Prozessfluid, mittels eines rotationssymmetrischen Hubsystems, bestehend aus mindestens einem bewegten rotationssymmetrischen Arbeitskolben mit je einem Führungszylinder, und der Arbeitskolben an dem im Führungszylinder befindlichen Kolbenende mindestens eine auf der äußeren Oberfläche radial umlaufende Verstärkung aufweist, so dass der Innenraum zwischen Führungszylinder und Arbeitskolben in mindestens zwei Zylinderräume geteilt wird, und mindestens eine Öffnung im Führungszylinder zu jedem dieser Zylinderräume führt, und diese Bohrungen direkt oder über Rohrleitungen mit mindestens einem Ventil verbunden sind, welches die Be- und Entleerung der Zylinderräume des Führungszylinders regelt, dadurch gekennzeichnet, dass das Fluid zum Antrieb des Arbeitskolbens mit der Hauptkomponente des im Druckbehälter eingesetzten Fluids identisch ist, wobei der Kopfbereich des Arbeitskolbens mindestens zum Teil das Verschlussteil oder starr mit dem Verschlussteil des Behälters verbunden ist und dieses Verschlussteil bezogen auf den Arbeitskolben ebenfalls im Wesentlichen entlang der Rotationsachse verfahren wird und der Behälter gegenüber der Stirnfläche des Arbeitskolbens angeordnet ist und die Bodenfläche des Arbeitskolbens größer als die Anpressfläche, welche zwischen Basisteil und Verschlussteil des Behälters angeordnet ist.

Weiterhin ist mindestens eine der Gleitflächen, welche auf den Zylinderinnen- und den Kolbenoberflächen in den Bereichen lokalisiert sind, in denen sich Zylinder- und Kolbenflächen berührend gegenüberliegen und parallel zur Rotationsachse gegeneinander bewegt werden, ein Tragverhältnis über 60% aufweist, wobei das Tragverhältnis das Verhältnis des Anteils der Erhebungen zum Anteil der Vertiefungen in der Oberflächenstruktur ist und/oder diese Gleitfläche gehärtet ist, um ein Festfressen der Gleitflächen zu verhindern.

Vorteilhafterweise werden austenitische Werkstoffe eingesetzt, wobei die erfindungsgemäße Vorrichtung nicht auf diese Werkstoffgruppe beschränkt ist.

Die Verfahren zur Herstellung hoher Tragverhältnisse sind in der Literatur weitreichend beschrieben. Als mögliche Verfahren stehen z. B. das Honen, Läppen oder Rollieren zur Verfügung. Die Härtung der so vorbehandelten Oberflächen kann mittels Plasmanitrierung, Kolsterisierung oder Hartverchromung realisiert werden. Diese Verfahren sind als Stand der Technik zu betrachten und werden von Spezialfirmen kommerziell angeboten.

Bezüglich einer optimierten Regelung besteht eine erfindungsgemäße Ausgestaltung der offenbarten Vorrichtung in einer Einbindung von mindestens einer Drosselstufe und/oder mindestens einem weiteren Ventil in den Ver- und Entsorgungsleitungen und/oder den Ableitungen. Damit wird sichergestellt, dass der Anpressdruck des Arbeitskolbens an der Stirnfläche auch während der unterschiedlichen Beaufschlagungs- oder Entspannungsschritte, welche im Wesentlichen durch das Ventil ausgelöst werden, immer größer ist als der Druck im Prozessraum.

Die Funktion der offenbarten Vorrichtung läuft derart, dass durch die Schaltung des Ventils der Hohlraum unterhalb der Bodenfläche des Arbeitskolbens und der Behälter über die Druckleitungen und die Bohrungen mit Fluid gefüllt werden, und somit
- der Arbeitskolben aus der Ausgangsposition *"Offener Behälter"*, bei welcher der Behälter geöffnet ist, in die Position *"Geschlossener Behälter"* gefahren wird, bei welcher der Behälter geschlossen ist, und den Behälter verschließt, und
- nach Ende des Prozesses im Behälter das Ventil derart geschaltet wird, dass das Fluid im unteren Zylinderhohlraum und im Prozessraum entspannt wird, und
- anschließend durch weitere Ventilschaltung der obere Zylinderhohlraum im Führungszylinder über die Druckleitung und die Bohrung mit Fluid beaufschlagt wird, so dass der Arbeitskolben wieder in die Ausgangsposition "Geöffneter Behälter" verfährt.

**[0021]** Wie vorstehend genannt, besteht eine vorteilhafte Verfahrensführung darin, dass bei der gleichzeitigen Beaufschlagung des Prozessraumes und des unteren Zylinderhohlraums mit Fluid, der Zulauf in den Behälter über den Leitungsweg gedrosselt oder zeitlich verzögert wird, so dass der Anpressdruck in der Dichtfläche zwischen Basis- und Verschlussteil des Behälters immer größer als der Druck im Behälter ist.

**[0022]** Analog zur vorgenannten Optimierung des Verfahrens ist eine Weiterentwicklung darin zu sehen, dass bei der gleichzeitigen Entspannung des Behälters und des unteren Zylinderhohlraums der Fluidabfluss aus dem unteren Zylinderhohlraum gedrosselt und/oder zeitlich verzögert wird, so dass der Anpressdruck in der Dichtfläche zwischen Basis- und Verschlussteil des Behälters immer größer als der Druck im Prozessraum ist.

Durch die direkte Kopplung der Drücke im Prozessraum und in den Zylinderhohlräumen sowie die Verschaltung der Fluidströme bei den einzelnen Hubschritten vereinfacht sich den Steuerung und Regelung im Vergleich zu Systemen, wie sie aus dem Stand der Technik bekannt sind, deutlich, und hohe Hubzahlen sind auch bei sehr hohen Drücken realisierbar.

Eine besonders vorteilhafte Verfahrensführung besteht darin, dass als Fluid ein überkritisches Fluid eingesetzt wird und dieses Fluid zum Beispiel Kohlendioxid (CO₂), Druckluft, Stickstoff oder ein inertes Gas ist, oder aus einer Mischung daraus besteht. Dabei kann dem Fluid eine Reinigungssubstanz in geringen Prozentsätzen beigefügt sein.

Eine weitere vorteilhafte Ausgestaltung des Verfahrens besteht darin, dass als Fluid ein leichtflüchtiges Medium aus der Gruppe verwendet wird, die durch Ethanol, Methanol, Isopropanol, und vergleichbare Stoffe oder Mischungen daraus gebildet ist, oder ein Gas verwendet wird, welches im Wesentlichen aus CO₂, Sauerstoff, Stickstoff, einem Edelgas oder Mischungen daraus besteht. Dabei kann dem Fluid eine Reinigungssubstanz in geringen Prozentsätzen beigefügt sein.

Die vorgenannte erfindungsgemäßen Vorrichtung und das Verfahren ist vorteilhafterweise geeignet, um an der Stirnfläche des Arbeitskolbens und/oder in dem Prozessraum regelmäßig ein Arbeitsdruck über 160 bar zu erreicht beziehungsweise die Vorrichtung und das Verfahren bei Drücken über160 bar zu betreiben.

Vorteilhafterweise wird der erfindungsgemäße Apparat für Prozesse genutzt, die im Zusammenhang mit einer Anwendung, Produktion oder einem Verfahren der Halbleiterindustrie und/oder Waferherstellung stehen.

Weitere vorteilhafte Bereiche zum Einsatz der offenbarten Vorrichtung sind Prozesse, Anwendungen oder Produktionsverfahren der optischen Industrie, der pharmazeutischen und/oder der medizinischen Industrie. Gerade in der medizinisch-pharmazeutischen Industrie sind viele Autoklav-Prozesse, Verpack- oder Pressvorgänge erforderlich, die mittels der offenbarten Vorrichtung vereinfacht und verbessert werden können.

Damit ist vorteilhafterweise in Bezug auf bekannte Hubsystem eine Vorrichtung offenbart, die in allen Industriezweigen sehr vorteilhaft einsetzbar ist, in denen äußerst hohe Anforderungen bezüglich Reinheit der Prozesse besteht, bei gleichzeitiger Forderung nach hohen Durchsatzraten und hohen Drücken. Es ist durch den Wegfall zusätzlicher Arbeitsfluide und die beschriebene Bauform sowie die minimalisierten Bewegungsverläufe sehr kompakt und robust, sodass auch in ökonomischer Hinsicht gegenüber dem Stand der Technik deutliche Vorteile bestehen.

Die Figuren 1 bis 3 zeigen die Vorrichtung im Längsschnitt.
Fig. 1: Hubsystem und Stelleinheit
Fig. 2 Hubsystem in der Ausgangsposition (*"Geöffneter Behälter"*)
Fig.3 Hubsystem (*"Geschlossener Behälter"*)

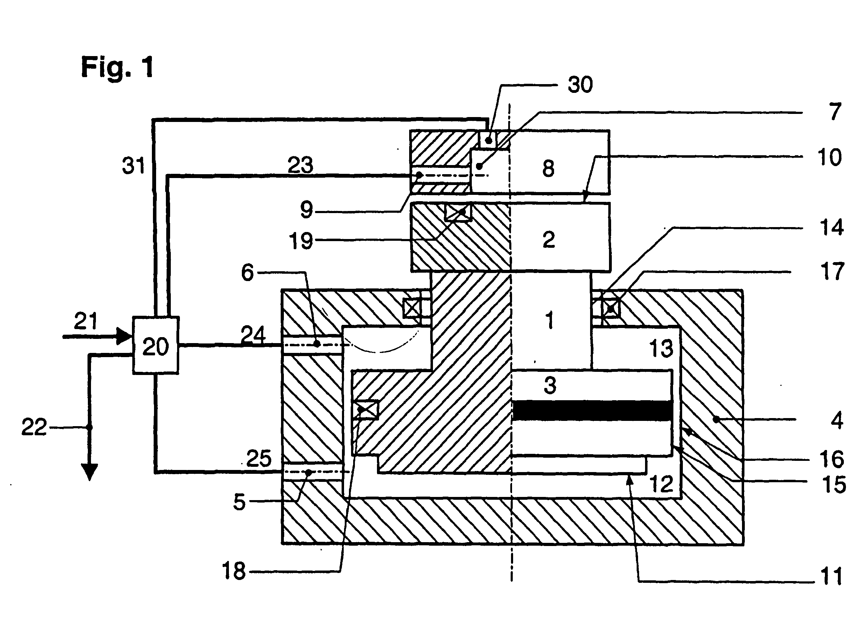

Anhand von Erläuterungen und einem Beispiel soll die Vorrichtung und das Verfahren näher beschrieben werden. Fig. 1 zeigt das Hubsystem und eine Stelleinheit 20, wobei hier beispielhaft alle Druckleitungen und die Zu- und Ableitung diese Stelleinheit 20 durchlaufen.

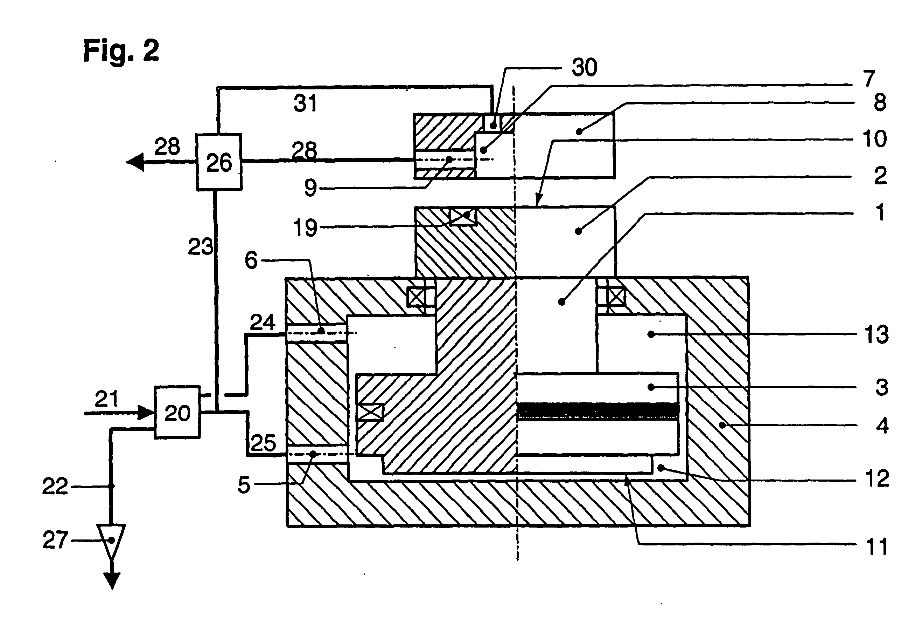

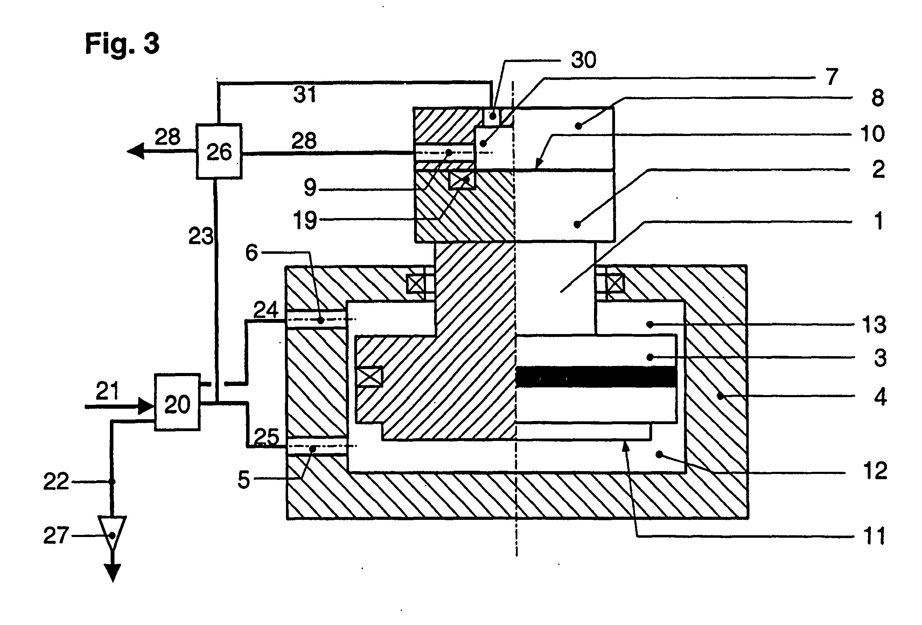

Fig. 2 und Fig. 3 zeigen beispielhaft die Stelleinheit als Ventil 20, Ventil 26 und Drossel 27. Weiterhin zeigen sie die Durchführung des offenbarten Verfahrens unter Einbindung der vorgenannten und erfindungsgemäßen Vorrichtung. Diese läuft derart, dass durch die Schaltung des Ventils 20 der Hohlraum unterhalb der Bodenfläche 11 des Arbeitskolbens 1 und der Behälter 8 über die Druckleitungen und die Bohrungen mit Fluid beaufschlagt werden, wobei Ventil 26 die Druckleitung 23 verschließ, und somit
- der Arbeitskolben 1 aus der Ausgangsposition *"Offener Behälter"* (Fig. 2) in die Position *"Geschlossener Behälter"* (Fig. 3) gefahren wird und den Behälter verschließt, und
- nach Prozessende das Ventil 20 derart geschaltet wird, dass das Fluid im unteren Zylinderhohlraum 12 und im Prozessraum 7 entspannt wird, und
- anschließend durch weitere Ventilschaltung der obere Zylinderhohlraum 13 im Führungszylinder über die Druckleitung 24 und die Bohrung 6 mit Fluid beaufschlagt wird, so dass der Arbeitskolben 1 wieder in die Ausgangsposition "Geöffneter Behälter" verfährt.

Anhand eines Beispiels soll nachstehend die erfindungsgemäße Vorrichtung und das Verfahren zu dessen Einsatz näher erläutert werden.

Wie in Fig. 2 dargestellt, umfasst die Vorrichtung eine Vorrichtung zum Verschließen eines Behälters, welcher im Wesentlichen aus einem statischen Basisteil und einem mobilen Verschlussteil besteht. Zwischen den beiden Teilen ist eine Dichtfläche angeordnet. Im Prozessraum, der sich zwischen den beiden Teilen ausbildet, werden Prozesse mit mindestens einem Prozessfluid durchgeführt. Der Verschluss geschieht mittels eines rotationssymmetrischen Hubsystems, das aus einem bewegten rotationssymmetrischen Arbeitskolben 1 mit einem Führungszylinder 4 besteht.

Das im Führungszylinder 4 befindlichen Kolbenende weist eine auf der äußeren Oberfläche radial umlaufende Verstärkung 3 auf, so dass der Innenraum zwischen Führungszylinder und Arbeitskolben in zwei Hohlräume geteilt wird. Je eine Öffnung im Führungszylinder führt zu jedem der beiden Hohlräume, wobei diese Bohrungen über Druckleitungen mit einem Ventil verbunden sind. Über eine Zuleitung 21 wird das Prozess- und Arbeitsfluid zugeführt, so dass für den Kolbenantrieb und den Prozess im Prozessraum 7 im Wesentlichen das selbe Fluid genutzt wird. Dabei kann dem Fluid ein Additiv zugesetzt sein, dass für den Prozess im Prozessraum 7 erforderlich ist.

Die Stirnseite des Arbeitskolbens stellt das Verschlussteil des Behälters 8 dar und wird entlang der Rotationsachse senkrecht verfahren. Die Bodenfläche 11 des Arbeitskolbens 1 ist größer als die Anpressfläche zwischen Basisteil und Verschlussteil des Behälters.

Die vorstehend beschriebene Vorrichtung umfasst, wie in Fig. 2 und Fig. 3 dargestellt, ein zentrales Ventil 20 sowie die in Ableitung 22 eingebunden Drossel 27 und das in die Zuleitung 23 eingebrachte Ventil 26.
- Zu Beginn eines Hubzyklusses ist das Ventil 26 geschlossen. Durch
- Stellung des Ventils 20 wird über die Druckleitung 25 und die Bohrung 5 der untere Zylinderhohlraum 12 mit Fluid beaufschlagt, wobei zeitgleich Fluid aus dem oberen Zylinderraum 13 über die Bohrung 6 und die Druckleitung 24 entweichen kann. Die Leitungen 23 und 24 sind anfänglich durch die Ventile 20 und 26 verschlossen. Durch das Erreichen eines definierten Drucks in der Druckleitung 23 bzw. in der Stirnfläche 10 oder nach einer festgelegten Zeit,
- wird das Ventil 26 geöffnet und der Prozessraum 7 über die Bohrung 9 und die Druckleitung 29 mit Fluid beaufschlagt. Das beladene Prozessfluid fließt über die Bohrung 30 und die Druckleitung 31 ab. Nach Ende des Prozesses im Prozessraum 7 wird
- durch Stellung des Ventils 28 der Druck im Prozessraum 7 entspannt, indem das Fluid über Bohrung 9 und Druckleitung 28 entweichen kann. Während dieses Entspannungsvorgangs oder anschließend, wird durch
- Stellung des Ventils 20 der obere Zylinderraum 13 über die Druckleitung 24 und die Bohrung 6 mit Fluid beaufschlagt und zeitgleich über die Druckleitung 25 und die Bohrung 5 der Druck im unteren Zylinderraum 12 entspannt. Dadurch verfährt der Arbeitskolben in die Position "Geöffneter Behälter" und der Prozessraum kann entleert bzw. beladen werden. Nach
- Stellung des Ventils 28, welches die Absperrung der Druckleitung 23 bewirkt, ist wieder die Ausgangsposition des Hubzyklusses erreicht.

Wie vorstehend genannt, besteht eine vorteilhafte Funktion der Reinraumvorrichtung darin, dass bei der gleichzeitigen Beaufschlagung des Prozessraumes 7 und des unteren Zylinderhohlraums 12 mit Fluid, der Zulauf in den Behälter 8 über den Leitungsweg 23 gedrosselt oder zeitlich verzögert wird, so dass der Anpressdruck in der Dichtfläche zwischen Basis- und Verschlussteil des Behälters immer größer als der Druck im Behälter ist.

Analog zur vorgenannten Optimierung ist eine vorteilhafte Ausgestaltung darin zu sehen, dass bei der gleichzeitigen Entspannung des Behälters 8 und des unteren Zylinderhohlraums 12 der Fluidabfluss aus dem unteren Zylinderhohlraum 12 gedrosselt oder zeitlich verzögert wird, so dass der Anpressdruck in der Dichtfläche zwischen Basis- und Verschlussteil des Behälters 8 immer größer als der Druck im Prozessraum 7 ist.

## Patentansprüche

1. Hochdruckvorrichtung zum Verschließen eines Behälters 8 im Reinraum, welcher mindestens aus einem Basisteil und einem Verschlussteil besteht und eine Dichtfläche zwischen diesen beiden Teilen aufweist, für die Durchführung eines Prozesses mit mindestens einem Prozessfluid, mittels eines rotationssymmetrischen Hubsystems, bestehend aus mindestens einem bewegten rotationssymmetrischen Arbeitskolben 1 mit je einem Führungszylinder 4, und der Arbeitskolben 1 an dem im Führungszylinder 4 befindlichen Kolbenende mindestens eine auf der äußeren Oberfläche radial umlaufende Verstärkung 3 aufweist, so dass der Innenraum zwischen Führungszylinder 4 und Arbeitskolben 1 in mindestens einen unteren Zylinderhohlraum 12 und einen oberen Zylinderhohlraum 13 geteilt wird, und mindestens eine Bohrung 5 und 6 im Führungszylinder 4 zu jedem dieser Zylinderhohlräume 12 und 13 führt, und diese Bohrungen 5 und 6 direkt oder über Rohrleitungen 24 und 25 mit mindestens einer Stell- und Regeleinheit 20 verbunden sind, welche die Be- und Entleerung der Zylinderräume 12 und 13 des Führungszylinders 4 regelt
- wobei die Stirnseite des Arbeitskolbens mindestens zum Teil das Verschlussteil oder starr mit dem Verschlussteil des Behälters verbunden ist und dieses Verschlussteil bezogen auf den Arbeitskolben ebenfalls im Wesentlichen entlang der Rotationsachse verfahren wird und der Behälter gegenüber der Stirnseite des Arbeitskolbens angeordnet ist und die Bodenfläche des Arbeitskolbens größer als die Anpressfläche zwischen Basisteil und Verschlussteil des Behälters ist und **dadurch gekennzeichnet, dass**
- das Fluid zum Antrieb des Arbeitskolbens 1 mit der Hauptkomponente des im Druckbehälter 8 eingesetzten Fluids identisch ist und das Fluid entweder ein überkritisches Gas oder ein leichtflüchtiges Medium ist,
- mindestens eine der Gleitflächen 14,15 und 16, welche auf den Zylinderinnen- und den Kolbenoberflächen in den Bereichen lokalisiert sind, in denen sich Zylinder- und Kolbenflächen berührend gegenüberliegen und parallel zur Rotationsachse gegeneinander bewegt werden, ein Tragverhältnis über 60% aufweist, wobei das Tragverhältnis das Verhältnis des Anteils der Erhebungen zum Anteil der Vertiefungen in der Oberflächenstruktur ist

2. Vorrichtung nach Anspruch 1, **dadurch gekennzeichnet, dass** mindestens eine der Gleitflächen 14, 15 und 16, welche auf den Zylinderinnen- und den Kolbenoberflächen in den Bereichen lokalisiert sind, in denen sich Zylinder- und Kolbenflächen berührend gegenüberliegen und parallel zur Rotationsachse gegeneinander bewegt werden, gehärtet ist.

3. Vorrichtung nach einem der Ansprüche 1 oder 2, **dadurch gekennzeichnet, dass** mindestens eine der mit den Bohrungen verbundenen Leitungen direkt vor oder direkt nach dem Ventil eine Drosselstufe enthält.

4. Vorrichtung nach einem der Ansprüche 1 bis 3, **dadurch gekennzeichnet, dass** das überkritische Fluid zum Beispiel Kohlendioxid (CO₂), Druckluft, Stickstoff oder ein inertes Gas ist, oder aus einer Mischung daraus besteht.

5. Vorrichtung nach einem der Ansprüche 1 bis 3, **dadurch gekennzeichnet, dass das** leichtflüchtige Medium aus der Gruppe stammt, die durch Ethanol, Methanol, Isopropanol, und vergleichbare Stoffe oder Mischungen daraus gebildet ist, oder ein Gas verwendet wird, welches im Wesentlichen aus CO₂, Sauerstoff, Stickstoff, einem Edelgas oder Mischungen daraus besteht.

6. Vorrichtung nach einem der Ansprüche 1 bis 5, **dadurch gekennzeichnet, dass** an der Stirnfläche des Arbeitskolbens regelmäßig ein Arbeitsdruck über 160 bar erreicht wird.

7. Verfahren zum Einsatz der Vorrichtung nach einem der Ansprüche 1 bis 6, **dadurch gekennzeichnet, dass** es mit einer durch
■ die Schaltung des Ventils der Hohlraum unterhalb der Bodenfläche des Arbeitskolbens und der Behälter über die Druckleitungen und die Bohrungen mit Fluid gefüllt werden, und somit
■ der Arbeitskolben aus der Ausgangsposition *"Offener Behälter",* bei welcher der Behälter geöffnet ist, in die Position *"Geschlossener Behälter"* gefahren wird, bei welcher der Behälter geschlossen ist, und den Behälter verschließt, und
■ nach Prozessende in der Stell- und Regelstufe derart geschaltet wird, dass das Fluid im Hohlraum unterhalb der Bodenfläche und im Prozessraum entspannt wird, und
■ anschließend durch weitere Ventilschaltung der obere Hohlraum im Führungszylinder über die Druckleitung und die Bohrung mit Fluid beaufschlagt wird, so dass der Arbeitskolben wieder in die Ausgangsposition "Geöffneter Behälter" verfährt.

8. Verfahren nach Anspruch 7, **dadurch gekennzeichnet, dass** in dem Behälter regelmäßig ein Druck über 160 bar erreicht wird.

9. Verfahren nach Anspruch 7 oder 8, **dadurch gekennzeichnet, dass** die Stell- und Regelstufestufe mindestens ein Ventil umfasst.

10. Verfahren nach einem der Ansprüche 7 bis 9, **dadurch gekennzeichnet, dass** die Stell- und Regelstufestufe mindestens eine statische oder dynamische Fluiddrossel umfasst.

11. Verfahren nach einem der Ansprüche 7 bis 10, **dadurch gekennzeichnet, dass** bei der gleichzeitigen Beaufschlagung des Behälters und des Zylinderhohlraums mit Fluid, der Zulauf in den Behälter gedrosselt und/oder zeitlich verzögert wird.

12. Verfahren nach einem der Ansprüche 7 bis 11, **dadurch gekennzeichnet, dass** bei der gleichzeitigen Entspannung des Drucks im Behälter und im unteren Zylinderhohlraum der Fluidabfluss aus dem Zylinderhohlraum unterhalb der Bodenfläche des Arbeitszylinders gedrosselt und/oder zeitlich verzögert wird.

13. Verwendung des Verfahrens oder der Vorrichtung nach einem der Ansprüche 1 bis 12, **dadurch gekennzeichnet, dass** die Vorrichtung oder das Verfahren im Zusammenhang mit einer Anwendung, Produktion oder einem Verfahren der Halbleiterindustrie und/oder Waferherstellung eingesetzt wird.

14. Verwendung des Verfahrens oder der Vorrichtung nach einem der Ansprüche 1 bis 12, **dadurch gekennzeichnet, dass** die Vorrichtung oder das Verfahren im Zusammenhang mit einer Anwendung, Produktion oder einem Verfahren der optischen Industrie eingesetzt wird.

15. Verwendung des Verfahrens oder der Vorrichtung nach einem der Ansprüche 1 bis 12, **dadurch gekennzeichnet, dass** die Vorrichtung oder das Verfahren im Zusammenhang mit einer Anwendung, Produktion oder einem Verfahren der pharmazeutischen oder medizinisch-pharmazeutischen Industrie eingesetzt wird.

## Claims

1. High-pressure device for operating closures of vessel (8) and suited for clean-room applications, which consists of a base part and a closure part with a sealing member arranged between said parts, and for implementing the process with at least one process fluid and by means of a rotation-symmetric reciprocating piston system, said system comprising at least one rotation-symmetric hydraulic piston (1) with one guide cylinder (4) each, hydraulic piston (1) being linked to guide cylinder (4) at the piston end that has at least one radial and circumferential reinforcement (3) on its external surface so that the inner space between guide cylinder (4) and hydraulic piston (1) is separated into at least one lower cylinder chamber (12) and an upper cylinder chamber (13) and at least one bore (5 and 6) is provided in the guide cylinder (4) for each of cylinder chambers (12 and 13), said bores (5 and 6) being connected to at least one setting and control unit (20) either direct or via lines (24 and 25), said settable unit controlling the delivery to and the discharge from cylinder chambers (12 and 13) of guide cylinder (4), the upper face of the hydraulic piston either constituting part of the closure or being provided with a rigid connection to said closure of the vessel and that the major part of this closure also moves essentially along the axis of rotation referred to the hydraulic piston, the vessel being arranged on the opposite side of the upper face of the hydraulic piston and that the lower face of the hydraulic piston is larger than the contact surface between the base part and the closure part of the vessel, **characterised in that**
- the fluid for driving hydraulic piston (1) is identical with the main component of the process fluid used in pressure vessel (8) and the process fluid is either a supercritical gas or a highly volatile fluid, and
- at least one of sliding surfaces (14, 15 and 16), which are located on the inner wall side of the cylinder and on the respective piston surfaces and where the cylinder and the piston surfaces come into contact as members facing each other and moving parallel to the axis of rotation, has a >60% support ratio, said figure being the ratio of the portion of peaks in relation to the portion of valleys in the surface structure.

2. Device according to claim 1,
**characterised in that** at least one of sliding surfaces (14, 15 and 16), which are located on the inner wall side of the cylinder and on the respective piston surfaces and where the cylinder and the piston surfaces come into contact as members facing each other and move parallel to the axis of rotation, is subjected to a hardening process.

3. Device according to one of the preceding claims 1 or 2,
**characterised in that** at least one of the lines connected to the bores is provided with a restrictor directly upstream or downstream of the valve.

4. Device according to one of the preceding claims 1 to 3,
**characterised in that** the supercritical fluid is, for example, carbon dioxide (CO₂), compressed air, nitrogen or inert gas or a mixture thereof.

5. Device according to one of the preceding claims 1 to 3,
**characterised in that** the highly volatile fluid is taken from the group constituted by ethanol, methanol, isopropanol and comparable substances or mixtures thereof, or as option a gas mainly consisting of CO₂, oxygen, nitrogen, a noble gas or mixtures thereof.

6. Device according to one of the preceding claims 1 to 5,
**characterised in that** an operating pressure of >160 bar is regularly reached at the upper face of the hydraulic piston.

7. Process for the utilisation of the device according to one of the preceding claims 1 to 6,
**characterised in that**
■ the switching of the valve initiates the filling with fluid of the space underneath the lower face of the hydraulic piston and the vessel via the delivery lines and the bores with the aid of fluid,
■ the hydraulic piston thus moves from the starting position "Vessel open" so that the vessel is opened, to the position "Vessel closed" so that the vessel is closed,
■ the setting and control unit is switched at the end of the process in the vessel in such a manner that the fluid in the space underneath the lower piston end and in the process chamber is flashed,
■ further valve switching ensures that the upper cylinder chamber in the guide cylinder is filled with fluid via the delivery line and the bore so that the hydraulic piston returns to its starting position "Vessel open".

8. Process according to claim 7,
**characterised in that** the regular pressure in the vessel is >160 bar.

9. Process according to claims 7 or 8,
**characterised in that** the setting and control unit comprises at least one valve.

10. Process according to one of the preceding claims 7 to 9,
**characterised in that** the setting and control unit comprises at least one static or dynamic fluid restrictor.

11. Process according to one of the preceding claims 7 to 10,
**characterised in that** the feed stream to the vessel and the cylinder chamber is restricted and/or delayed when the vessel and the cylinder chamber are pressurised with fluid simultaneously.

12. Process according to one of the preceding claims 7 to 11,
**characterised in that** a simultaneous depressurisation of the vessel and the lower cylinder chamber takes place, the fluid discharge stream from the cylinder chamber underneath the lower face of the hydraulic piston being restricted and/or delayed.

13. Utilization of the process or device according to one of the preceding claims 1 to 12,
**characterised in that** the device or process is used in conjunction with the application, production or a process applied in the semi-conductor industries and/or in the wafer production.

14. Utilization of the process or device according to one of the preceding claims 1 to 12,
**characterised in that** the device or process is used in conjunction with the application, production or a process applied in the optics industries.

15. Utilization of the process or device according to one of the preceding claims 1 to 12,
**characterised in that** the device or process is used in conjunction with the application, production or a process applied in the pharmaceuticals or medical/medicinal products industries.

## Revendications

1. Dispositif à haute pression pour la fermeture du récipient (8) et approprié au régime en salle blanche (clean room); le dit dispositif consiste en une partie de base et une partie de fermeture avec un élément d'étanchéité intercalée entre les deux parties et il est conçu pour la mise en oeuvre du procédé, à l'aide d'au moins un fluide de procédé et d'un mécanisme à course symmétrique par rapport à la rotation, ce dernier consistant principalement en un piston (1) mobile lié à un vérin de guidage (4), et que l'extrémité du dit piston hydraulique (1) dans le vérin de guidage (4) est dotée, au minimum, d'un renfort radial et circonférenciel (3) disposé sur sa surface extérieure, de sorte que l'espace intérieure qui se trouve entre le vérin (4) et le piston hydraulique (1) soit divisée, au minimum, en une chambre inférieure (12) et une chambre supérieure (13) et que, au moins, un alésage (5 ou 6) soit disposé dans le vérin de guidage (4) et connecté avec la chambre (12 ou 13), les dits alésages (5 et 6) étant branchés à un appareil de réglage et contrôle (20), soit en direct ou à l'aide des conduites (24 and 25), le dit appareil de réglage ayant la fonction de contrôler l'alimentation et la décharge des chambres (12 et 13) du vérin de guidage cylinder (4);
le côté supérieur du piston hydraulique constitue au moins une partie du mécanisme de fermeture ou bien il est fermement lié avec la dite fermeture du récipient et que la plus grande partie de la dite fermeture se déplace essentiellement le long de l'axe de rotation par rapport au piston hydraulique, le récipient étant disposé vis-à-vis du côté supérieur du piston hydraulique et que le côté inférieur a une surface qui est plus grande que la surface de contact entre la partie de base et la partie de fermeture du récipient,
**caractérisé en ce que**
- le fluide requis pour l'entraînement du piston hydraulique (1) est identique au principal composant du fluide de procédé utilisé dans le récipient à pression (8) et que le dit fluide est un gaz surcritique ou bien un fluide hautement volatile, et
- que, au minimum, l'une des surfaces de glissement (14, 15 et 16), qui se situent sur la paroi intérieure du vérin et sur les surfaces respectives du piston, dans la zone où les surfaces du vérin et du piston se touchent comme des éléments membres du dit mécanisme en position vis-à-vis et se déplacent parallèlement à l'axe de rotation, a un rapport d'appui de >60%, c.-à-d. le dit pourcentage correspond au rapport entre la partie des élévations (peaks) et celle des vallées (valleys) de la surface structurée.

2. Dispositif selon la revendication 1,
**caractérisé en ce que**, au minimum, une des surfaces de glissement (14, 15 et 16), qui se situe sur la paroi intérieure du vérin et sur les surfaces respectives du piston, dans la zone où les surfaces du vérin et du piston se touchent en position vis-à-vis et se déplacent parallèlement à l'axe de rotation, est soumise à un procédé de durcissement.

3. Dispositif selon l'une des revendications 1 ou 2,
**caractérisé en ce que**, au minimum, une des conduites liées aux dits alésages est dotée d'un élément étrangleur disposé directement en aval ou en amont de la vanne.

4. Dispositif selon l'une des revendications de 1 à 3,
**caractérisé en ce que** le fluide surcritique utilisé est, par exemple, du dioxyde de carbone (CO₂), de l'air comprimé, du nitrogène ou du gaz inerte, ou bien un mélange de ceux-ci.

5. Dispositif selon l'une des revendications de 1 à 3,
**caractérisé en ce que** le fluide facilement volatile utilisé tire son origine du groupe constitué par l'éthanol, le méthanol, l'isopropanol et des substances comparables, ou bien des mélanges de ceux-ci, ou il constiste alternativement en CO₂, oxygène, nitrogène, gaz rare ou bien mélanges de ceux-ci.

6. Dispositif selon l'une des revendications de 1 à 5,
**caractérisé en ce que** la pression de régime est régulièrement de >160 bars à la face supérieure du piston hydraulique.

7. Procédé pour l'utilisation du dispositif selon l'une des revendications de 1 à 6, **caractérisé en ce que**
■ la commutation de la vanne initie l'alimentation en fluide de l'espace au-dessous du côté inférieur du piston hydraulique et du récipient, à travers les conduites à pression et les alésages,
■ le piston hydraulique se déplace alors depuis la position de départ <<Récipient ouvert>>, dans laquelle le récipient se trouve ouvert, vers la position <<Récipient fermé>>, dans laquelle le récipient se trouve fermé,
■ l'unité de réglage et contrôle est commutée à la fin du procédé, de telle sorte que le fluide qui se trouve dans l'espace au-dessous du côté inférieur du piston et dans la chambre de procédé subit une détente,
■ la commutation ultérieure de la vanne se déroule de telle manière que l'éspace creuse supérieure dans le vérin de guidage est alimentée en fluide sous pression, à travers la conduite à pression et l'alésage respectif, de sorte que le piston hydraulique retourne vers sa position de départ <<Récipient ouvert>>.

8. Procédé selon la revendication 7,
**caractérisé en ce que** la pression régulière dans le récipient est de >160 bars.

9. Procédé selon la revendication 7ou 8,
**caractérisé en ce que** l'unité de réglage et de contrôle englobe au moins une vanne.

10. Procédé selon l'une des revendications de 7 à 9,
**caractérisé en ce que** l'unité de réglage et de contrôle englobe au moins un élément étrangleur statique ou danymique.

11. Procédé selon l'une des revendications de 7 à 10,
**caractérisé en ce que** lors de la mise sous pression simultanée du récipient et de la chambre du vérin, le débit de fluide d'alimentation vers le récipient est sousmis à un étranglement et/ou une temporisation.

12. Procédé selon l'une des revendications de 7 à 11,
**caractérisé en ce que** lors de la détente simultanée de la pression dans le récipient et dans l'espace du vérin, l'effluent de fluide provenant de l'espace creuse du vérin, au-dessous de la face inférieure du piston hydraulique, est sousmis à un étranglement et/ou une temporisation.

13. Mise en oeuvre du procédé ou du dispositif selon l'une des revendications de 1 à 12,
**caractérisé en ce que** le dispositif ou le procédé est utilisé dans une combinaison avec une application, production ou procédure réalisée dans les industries des semi-conducteurs et/ou la production de microchips.

14. Mise en oeuvre du procédé ou du dispositif selon l'une des revendications de 1 à 12,
**caractérisé en ce que** le dispositif ou le procédé est utilisé dans une combinaison avec une application, production ou procédure réalisée dans les industries optiques.

15. Mise en oeuvre du procédé ou du dispositif selon l'une des revendications de 1 à 12,
**caractérisé en ce que** le dispositif ou le procédé est utilisé dans une combinaison avec une application, production ou procédure réalisée dans les industries pharmaceutiques ou médico-pharmaceutiques.
